# FASCICULE DE BREVET EUROPEEN

(11) **EP 3 809 233 B1**
(45) Date de publication et mention de la délivrance du brevet: **22.05.2024**
(21) Numéro de dépôt: 20201495.7
(22) Date de dépôt: 13.10.2020
(51) Int. Cl.: G05D 23/24, H05K 3/34, A47J 31/54, H05B 1/02

(54) **CIRCUIT DE CONTRÔLE DE MACHINE DE DISTRIBUTION DE BOISSONS A SECURITÉ ÉLECTRIQUE RENFORCÉE**
KONTROLLSCHALTKREIS EINER GETRÄNKEAUSGABEMASCHINE MIT VERSTÄRKTER ELEKTRISCHER SICHERHEIT
CIRCUIT FOR CONTROLLING A BEVERAGE DISPENSING MACHINE WITH ENHANCED ELECTRICAL SAFETY

(30) Priorité: 15.10.2019 FR 1911458
(43) Date de publication de la demande: 21.04.2021
(73) Titulaire: SEB S.A., 69130 Ecully (FR)
(72) Inventeur: LEBUFFE, Gilles, 50890 CONDE-SUR-VIRE (FR)
(74) Mandataire: Germain Maureau

(56) Documents cités:
- EP-A2- 2 218 375
- WO-A1-2015/000994
- US-A1- 2016 255 714
- US-A1- 2019 120 702
- Na: "How to monitor board temperature How to monitor board temperature", , 31 janvier 2019 (2019-01-31), XP055686017, Extrait de l'Internet: URL:https://www.ti.com/lit/an/snoaa26/snoa a26.pdf [extrait le 2020-04-15]

## Description

### DOMAINE DE L'INVENTION

La présente invention s'inscrit dans le domaine technique des composants électriques pour appareils domestiques, notamment pour machines de distribution de boissons chaudes. L'invention concerne une machine de distribution de boissons chaudes.

### ETAT DE LA TECHNIQUE

La norme européenne EN 60335, administrée par le Comité Européen de Normalisation Electrotechnique dit CENELEC, traite de la sécurité électrique des appareils électrodomestiques. Elle définit, entre autres, des exigences d'isolation électrique pour éviter de mettre en péril les utilisateurs des appareils électrodomestiques.

En particulier, les machines de distribution de boissons chaudes, telles que des machines à café domestiques ou professionnelles, entrent dans le champ d'application de la norme EN 60335.

Une disposition de la norme EN 60335 concerne les pistes de connexion électrique des cartes électroniques. Les cartes électroniques sont souvent désignées par le sigle PCB pour « Printed Circuit Board » selon la terminologie anglosaxonne. Les composants destinés à être portés à un potentiel électrique élevé (par exemple tension secteur en alternatif à 230 Volts, c'est-à-dire ayant une valeur efficace à 230 Volts) doivent être distants d'au moins 5 millimètres des composants destinés à être portés à un potentiel électrique plus faible (par exemple basse tension de 5 Volts en alternatif) présentant un danger moindre.

Cette exigence vise à permettre à l'utilisateur de toucher des éléments portés à la basse tension, en toute sécurité.

Par exemple, sur une machine de distribution de boissons chaudes, des capteurs électriques ou des boutons électriques portés à la basse tension sont accessibles pour les utilisateurs, par exemple des boutons pour commander la préparation de boissons. Les utilisateurs ne doivent en aucun cas risquer une exposition au niveau haut de tension (tension secteur) lorsqu'ils pressent les boutons ou touchent les capteurs de la machine.

Par ailleurs, une machine de distribution de boissons chaudes comprend typiquement un corps de chauffe dont la température est contrôlée afin de chauffer l'eau. Il s'agit par exemple d'une résistance dissipant partiellement sous forme de chaleur l'énergie électrique qui lui est communiquée. L'eau prévue pour être dispensée à l'utilisateur, typiquement mélangée à d'autres produits, est mise au contact du corps de chauffe. Un système électronique de la machine est utilisé pour le contrôle de l'alimentation du corps de chauffe.

Une autre disposition de la norme requiert une isolation par une paroi de 2mm mais un PCB d'épaisseur inférieure, typiquement de 1.6mm peut être accepté s'il présente un nombre suffisant de couches pour résister au test diélectrique de 3000V à l'échauffement maximal d'utilisation auquel on rajoute 50 Kelvin. Ce test diélectrique exclu l'utilisation de vias sur le PCB à proximité du composant de puissance.

Des machines de distribution de boissons chaudes de l'état de la technique comprennent une carte électronique équipée d'un composant de puissance à la sortie duquel est branché le corps de chauffe, pour contrôler l'alimentation électrique du corps de chauffe. On utilise par exemple un triac comme composant de puissance.

Au cours du fonctionnement de la machine, la température du composant de puissance doit être contrôlée pour ne pas dépasser un maximum de température supportable par le composant de puissance, faute de quoi le fonctionnement du corps de chauffe de la machine est altéré. Les conséquences d'un tel dysfonctionnement peuvent être graves.

Il est donc usuel de surveiller la température du composant de puissance par l'intermédiaire d'un capteur de température, par exemple une thermistance.

Il est connu de disposer le composant de puissance et le capteur de température sur une même face d'un PCB. Le composant de puissance et le capteur de température sont généralement placés très proches l'un de l'autre, afin que la mesure fournie par le capteur de température retranscrive une élévation de température du composant de puissance.

Toutefois, dans un contexte d'isolation électrique renforcée défini par la norme européenne EN 60335 mentionnée ci-avant, il n'est pas possible de placer un composant de puissance alimenté en haute tension au voisinage immédiat d'un capteur de température alimenté en basse tension, car la distance minimale de 5 millimètres ne serait pas respectée.

L'article « How to monitor board température » de la page internet https://www.ti.com /lit/an/snoaa26/snoaa26.pdf divulgue une surveillance de température d'un microcontrôleur.

Le document WO2015/000994 décrit un système dans lequel le capteur de température est placé à côté d'un composant dont il faut mesurer la température.

Le document EP2 218 375 divulgue un dispositif de chauffage pour une machine de préparation de boissons.

Les documents US2019/120702 et US2016/255714 présentent des architectures où le capteur de température est placé sur la face opposée et parallèle à la face où est monté un composant dont il faut surveiller la température.

Il n'existe donc pas de solution satisfaisante dans l'état de la technique pour fournir un contrôle efficace de la température d'un composant de puissance fonctionnant sur la tension secteur, dans un contexte d'isolation électrique renforcée.

### DESCRIPTION GENERALE DE L'INVENTION

Au regard de ce qui précède, il existe un besoin pour un système électronique de contrôle d'un corps de chauffe pour machine de distribution de boissons chaudes qui garantisse une isolation électrique satisfaisante entre un composant de puissance et un capteur de température, tout en demeurant peu complexe et peu encombrant.

Le besoin d'isolation électrique renforcée au sein du système électronique se cumule à un besoin de performance de la mesure de température du composant de puissance fournie par le capteur de température.

En effet, l'alimentation électrique du composant de puissance doit être interrompue dès que la température du composant de puissance dépasse un seuil critique.

Pour répondre à ces besoins, un premier objet de l'invention est définie dans la revendication 1.

Dans le système électronique de contrôle de corps de chauffe selon l'invention, si le composant de puissance subit une variation de température, le capteur de température situé sur la face opposée perçoit rapidement ladite variation de température.

Le capteur de température est par exemple placé sur une zone opposée à la zone occupée par le composant de puissance, afin de fournir une mesure de température fiable du composant de puissance.

De plus, le capteur de température et le composant de puissance étant disposés sur deux faces opposées du substrat électronique, le substrat électronique isole électriquement le capteur de température du composant de puissance.

Enfin, il est possible de réduire l'étalement total de l'ensemble formé par le composant de puissance et le capteur de température sur les faces du substrat électronique.

Le système électronique défini ci-avant est complété de façon optionnelle et non limitative par les caractéristiques techniques suivantes, prises seules ou dans l'une quelconque des combinaisons techniquement possibles :
- le capteur de température est une thermistance, de préférence du type à coefficient de température négatif.
- le composant de puissance est un triac.
- le composant de puissance recouvre une première zone de la première face du substrat électronique et le capteur de température recouvre une deuxième zone de la deuxième face du substrat électronique, la première zone étant opposée à la deuxième zone.
- une surface de la deuxième zone est inférieure à une surface de la première zone.
- la première face est sensiblement parallèle à la deuxième face, et le substrat électronique présente une épaisseur comprise entre 1 millimètre et 5 millimètres.
- la première face et la deuxième face comprennent chacune une partie opérative et une partie informationnelle, chaque partie opérative du système électronique étant séparée d'au moins 5 millimètres de chaque partie informative du système électronique.

Un deuxième objet de l'invention est une machine de distribution de boissons chaudes comprenant :
- un réservoir pour stocker un liquide,
- un corps de chauffe prévu pour chauffer une partie de liquide prélevée dans le réservoir,
- une alimentation électrique prévue pour alimenter le corps de chauffe,
- un système électronique tel que défini ci-avant, configuré pour contrôler l'alimentation électrique du corps de chauffe.

### DESCRIPTION GENERALE DES FIGURES

D'autres caractéristiques, buts et avantages de l'invention ressortiront de la description qui suit, qui est purement illustrative et non limitative, et qui doit être lue en regard des dessins annexés parmi lesquels :
La **Figure 1** représente de façon schématique une machine de distribution de boissons comprenant un système électronique selon l'invention.
La **Figure 2** est une vue schématique de côté d'un système électronique selon un mode de réalisation de l'invention.
La **Figure 3** est une vue partielle en perspective du système électronique selon la Figure 2, vu du dessous.

### DESCRIPTION DETAILLEE D'UN MODE DE REALISATION DE L'INVENTION

Dans la description ci-après et sur les figures annexées, on décrit à titre illustratif une machine à café à usage domestique ou professionnel, conçue pour préparer et dispenser des boissons de type café espresso.

On comprendra toutefois que le système électronique de l'invention peut être utilisé, avec les mêmes avantages, au sein de tout autre type de machine électrodomestique comportant un corps de chauffe et un composant de puissance pour le contrôle de l'alimentation électrique du corps de chauffe.

Sur l'ensemble des figures annexées et dans la description ci-après, les éléments similaires portent des références alphanumériques identiques.

### Machine de distribution de boissons chaudes

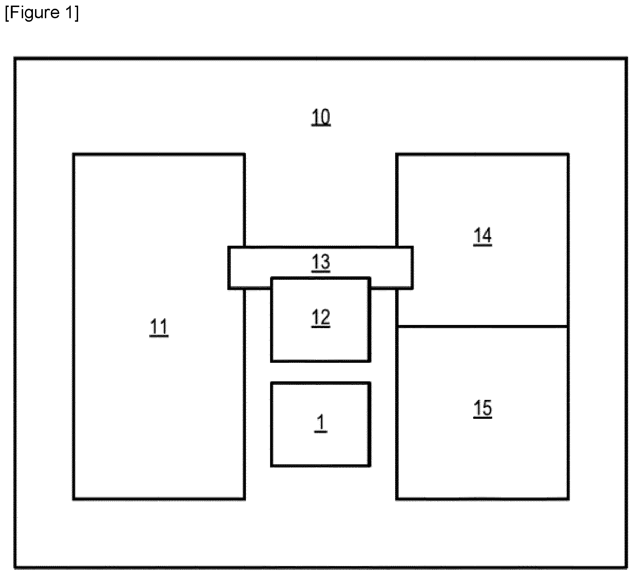

On a représenté fonctionnellement sur la **Figure 1** une machine de distribution 10 de boissons chaudes, selon un exemple de réalisation de l'invention. Il s'agit ici d'une machine à café domestique de type machine à espresso.

La machine de distribution 10 est destinée à être utilisée par des particuliers dans leur domicile, de préférence sans l'assistance d'un professionnel formé aux risques de sécurité électrique. Cette machine est par exemple branchée par l'utilisateur via un câble externe d'alimentation électrique (non représenté) à une prise secteur délivrant une tension alternative à 230 Volts.

La machine de distribution 10 comprend, entre autres, un réservoir principal 11, un corps de chauffe 12, un canal de distribution d'eau chaude 13, un espace de préparation de boissons 14, un espace de distribution de boissons 15 et un système électronique 1 (aussi dit PCB, ou « Printed Circuit Board ») pour le contrôle de l'alimentation électrique du corps de chauffe 12.

Le corps de chauffe 12 comprend typiquement une résistance électrique restituant une partie de l'énergie électrique qui lui est communiquée sous forme de chaleur.

Le réservoir principal 11 peut stocker du liquide, typiquement de l'eau à température ambiante. Au cours du fonctionnement de la machine de distribution 10, de l'eau est acheminée depuis le réservoir principal 11 vers l'espace de préparation de boissons 14, via le canal de distribution d'eau chaude 13. L'eau acheminée est préalablement chauffée par le corps de chauffe 12.

L'élévation de température de l'eau du canal de distribution d'eau chaude 13, et donc la température de la boisson préparée, sont fonction de la puissance électrique communiquée au corps de chauffe 12.

Ainsi, le système électronique 1 comprend un composant de puissance pour le contrôle de l'alimentation électrique fournie au corps de chauffe 12. Le composant de puissance est branché sur une carte électronique du système électronique 1.

### Circuit électronique de contrôle du corps de chauffe

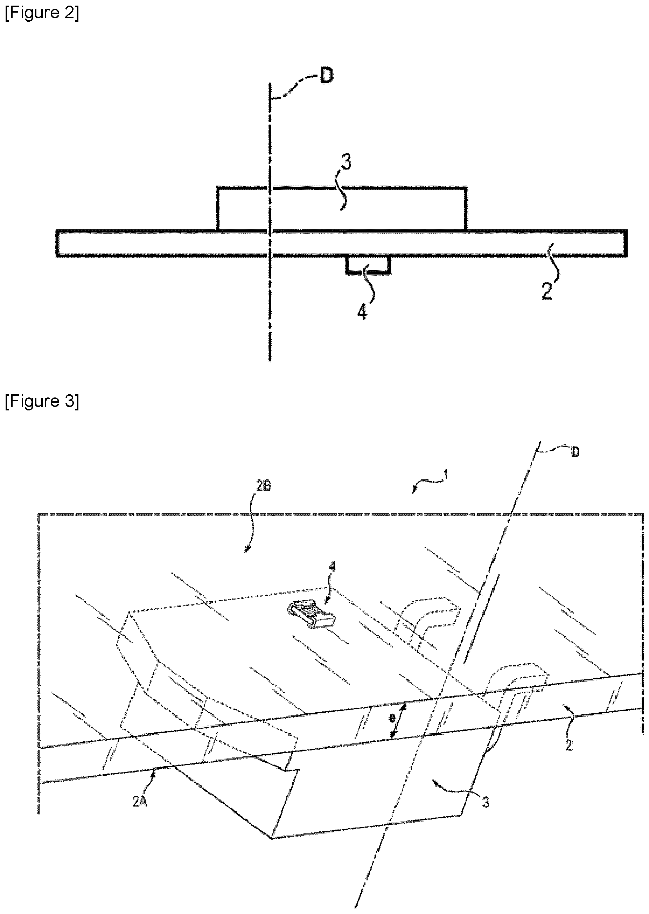

La **Figure 2** est une vue schématique du système électronique 1 de la machine de distribution 10 illustrée sur la Figure 1.

Le système électronique 1 comporte notamment une carte électronique 2, un composant de puissance 3 sous la forme d'un triac et un capteur de température 4 sous la forme d'une thermistance CTN (abrégée en « CTN 4 » dans la description ci-après). De manière connue, le sigle CTN désigne une thermistance à coefficient thermique négatif, c'est-à-dire un composant dont la résistance électrique diminue à mesure que sa température augmente. Toutefois, la CTN 4 peut être remplacée ou complétée par tout autre type de capteur de température compatible avec une utilisation au sein d'un circuit électronique.

Sur la Figure 2, le triac 3 et la CTN 4 sont vus de côté.

La **Figure 3** est une vue partielle du système électronique 1 de la Figure 2, vu de dessous, depuis la face de la carte électronique 2 comportant la CTN 4.

La carte électronique 2 est une carte double face. Ainsi, des composants électroniques peuvent être branchés sur une première face 2A de la carte électronique 2 et/ou sur une deuxième face 2B de la carte électronique 2.

Le triac 3 permet de contrôler le signal d'alimentation électrique délivré au corps de chauffe 12. La température du triac 3 est directement liée à la puissance électrique alimentant la résistance électrique du corps de chauffe 12. Ainsi, il est possible d'établir une régulation fine en température par la mesure de la température du triac 3. L'amorçage du triac 3 est effectué en délivrant un courant de gâchette d'intensité supérieure à un minimum. Ce minimum dépend du triac utilisé. Une fois amorcé, le triac 3 conduit le courant électrique entre ses deux broches aussi longtemps que l'intensité du courant entre les deux broches est supérieure à un seuil prédéterminé.

Il est avantageux d'utiliser un triac 3 comme composant de puissance, car celui-ci est capable de réagir à des temps de commutation courts de la tension électrique entre ses deux broches. Toutefois, un autre type de composant de puissance, et/ou un groupe de plusieurs composants de puissance, peu(ven)t être utilisé(s) dans le système électronique 1.

Le triac 3 est typiquement branché à une piste haute tension de la carte électronique 2. Ainsi, en cours de fonctionnement de la machine de distribution 10, le triac 3 est parcouru par un courant électrique à haute tension, par exemple une tension secteur alternative à 230 Volts.

Le triac 3 appartient à une partie opérative du système électronique 1.

De façon optionnelle, la partie opérative pour le contrôle de l'alimentation électrique du corps de chauffe 12 comporte non seulement le triac 3, mais également un relais électromécanique supplémentaire.

Typiquement, le triac 3 et ledit relais électromécanique supplémentaire sont branchés en parallèle, entre une source de courant électrique et le corps de chauffe.

Un triac et un relais électromécanique présentent une bonne complémentarité. En effet, le triac est réactif à des temps de commutation courts et le relais électromécanique est en mesure de supporter des courants d'intensité électrique élevée dans une phase opérationnelle où les temps de commutation sont longs.

Comme il a été indiqué ci-avant, le triac 3 fonctionne mal si la température du triac 3 dépasse un certain maximum pour lequel ce triac est conçu. Le triac 3 peut alors être endommagé. On encourt une défaillance du corps de chauffe et un potentiel dysfonctionnement global de la machine de distribution 10.

Une élévation importante de l'intensité du courant électrique entre les broches du triac 3 est susceptible d'engendrer une élévation importante de la température du triac 3. L'élévation de température se ressent notamment au niveau d'une semelle du triac.

Le système électronique 1 incorpore des moyens de traitement configurés pour interrompre l'alimentation électrique du triac 3 lorsque ledit signal dépasse un seuil prédéterminé, au cours du fonctionnement de la machine de distribution 10.

Le cas échéant, le relais électromécanique supplémentaire peut alors être fermé pour délester le passage du courant en dehors du triac 3 et continuer à alimenter le corps de chauffe 12.

Dans le cas où le composant de puissance dont il faut surveiller la température est un triac, on mesure de préférence la température de la semelle du triac, via la CTN 4.

Par exemple, les moyens de traitement pour la surveillance de la température du triac 3 comprennent un microcontrôleur intégré au système électronique 1.

Une borne de la CTN 4 est branchée à une piste bas niveau du microcontrôleur (non illustré sur les figures). On entend par « piste bas niveau » que ladite borne de la CTN 4 et un port d'entrée du microcontrôleur sont tous deux branchés sur une piste à basse tension de la carte électronique 2.

La piste à basse tension est une piste exposée, au cours du fonctionnement de la machine de distribution 10, à un courant électrique de tension inférieure à la tension du courant électrique délivré sur la piste haute tension mentionnée ci-avant. Par exemple, ladite piste basse tension est destinée à être soumise à un niveau de tension TBTS, pour Très Basse Tension de Sécurité.

La tension TBTS est choisie pour ne pas présenter de danger pour le corps humain en cas d'exposition. En alternatif, la tension TBTS est typiquement inférieure à 50 Volts en valeur efficace. Cette tension est donc bien inférieure à une tension usuelle du secteur.

Lorsque la semelle du triac 3 atteint une certaine température, le microcontrôleur détecte sur la piste bas niveau un signal électrique émis par la CTN 4. La CTN 4 est ainsi configurée pour délivrer un signal caractéristique de la température de la semelle du triac 3.

La CTN 4 appartient ainsi à une partie informationnelle du système électronique 1.

Les moyens de traitement sont configurés pour interrompre l'alimentation électrique du triac 3 lorsque le signal caractéristique délivré par le capteur de température (par la CTN 4 dans le présent exemple) dépasse un seuil prédéterminé.

Ce seuil prédéterminé constitue un seuil considéré comme critique, au-delà duquel on considère que des composants peuvent être endommagés et/ou que l'utilisateur encourt un danger. En interrompant de manière automatique l'alimentation électrique du triac 3 au-delà du seuil critique, ces risques sont contrôlés.

Lorsque le seuil critique est atteint, les moyens de traitement peuvent également actionner le relais supplémentaire branché en parallèle du triac 3. Le triac 3 se retrouve ainsi court-circuité mais le corps de chauffe 12 peut continuer à être alimenté. Néanmoins, une fine régulation en température permise par l'estimation de la température sur la semelle du triac 3 n'est plus possible.

Pour une bonne mesure de la température du triac 3, la CTN 4 est disposée au voisinage du triac 3.

Le triac 3 est branché sur la première face 2A de la carte électronique 2.

La CTN 4 est, quant à elle, branchée sur la deuxième face 2B de la carte électronique 2. La carte électronique 2 forme donc une couche intercalée entre le triac 3 et la CTN 4.

Selon une variante préférentielle, la CTN 4 est placée en alignement avec le triac 3 selon une direction D perpendiculaire à la carte électronique 2, c'est-à-dire qu'il existe quatre plans de l'espace parallèles à la direction D et tangents aux bords du triac 3, délimitant une portion de l'espace dans laquelle l'intégralité du triac 3 est comprise et dans laquelle au moins une partie de la CTN 4 est également comprise.

Ainsi, la CTN 4 est au moins partiellement située en superposition avec le triac 3 selon la direction D.

Selon cette variante préférentielle, la CTN 4 est donc proche du triac 3. Des variations de température du triac 3, et en particulier des variations de température de la semelle du triac 3, se traduisent de manière rapide par des variations de température au niveau de la CTN 4.

Il est possible de satisfaire aux exigences réglementaires en vigueur en matière de sécurité électrique des appareils électrodomestiques, sans devoir agencer le composant de puissance et le capteur de température à une distance de plus de 5 millimètres l'un de l'autre sur une même face.

Un premier avantage est d'assurer une mesure de température fiable et réactive du composant de puissance, et plus précisément de la semelle du triac dans cet exemple. En effet, il n'est pas nécessaire d'écarter le composant de puissance et le capteur de température à plus de 5 millimètres l'un de l'autre. Le capteur de température peut donc être placé plus proche du composant de puissance.

Un deuxième avantage est de réduire l'étalement de l'ensemble formé par le composant de puissance et le capteur de température, ces derniers n'étant pas disposés sur une même face de la carte électronique à plus de 5 millimètres l'un de l'autre.

Dans la mesure où le triac 3 et la CTN 4 sont disposés sur deux faces différentes de la carte électronique 2, le triac 3 et la CTN 4 sont isolés électriquement l'un de l'autre. Il n'est pas nécessaire de prévoir une distance minimale dans l'espace entre le triac 3 et la CTN 4 qui soit supérieure à 5 millimètres.

De préférence, le triac 3 est branché sur une piste à haute tension de la première face 2A et la CTN 4 est branchée sur une piste à basse tension de la deuxième face 2B.

Des essais de rigidité diélectrique à 3000 Volts, combinés à une évaluation de la qualité thermique du matériau de la carte électronique 2, montrent que l'isolation électrique au sein de la carte électronique 2 est satisfaisante entre le composant de puissance et le capteur de température. Au cours d'essais en fonctionnement, l'élévation de température de la carte électronique 2 ne dépasse pas en moyenne les 75 degrés Kelvin, et demeure en tout cas inférieure à 120 degrés Kelvin.

En tout état de cause, l'isolation électrique au sein du système électronique 1 est conforme aux exigences réglementaires en termes de sécurité électrique des appareils électrodomestiques.

De manière préférentielle, le matériau du substrat électronique, ici le matériau de la carte électronique 2, présente une bonne conductivité thermique. Le matériau de la carte électronique 2 est de préférence un polymère thermodurcissable, ici une résine époxy.

Un avantage est de rendre des variations de température au niveau de la semelle du triac 3 plus rapidement perceptibles au niveau de la CTN 4.

De préférence, une épaisseur du substrat, ici une épaisseur e de la carte électronique 2 entre la première face 2A et la deuxième face 2B qui sont sensiblement parallèles, est inférieure à 5 millimètres selon la direction D.

De manière préférentielle, l'épaisseur e de la carte électronique selon la direction D est comprise entre 1 millimètre et 5 millimètres, encore plus préférentiellement entre 1 millimètre et 3 millimètres.

On considère ici que l'épaisseur de la carte électronique est uniforme ; dans le cas où un substrat électronique d'épaisseur non uniforme serait utilisé, c'est l'épaisseur maximale du substrat électronique selon la direction D qui est de préférence choisie inférieure à 5 millimètres.

Grâce à l'épaisseur réduite du substrat interposé entre le composant de puissance et le capteur de température, on gagne en précision et en réactivité de la mesure de température du composant de puissance, par rapport à la situation où le composant de puissance et le capteur de température seraient disposés sur une même face du substrat à une distance de plus de 5 millimètres l'un de l'autre.

Pour respecter les dispositions de la norme européenne EN 60335 pour les appareils électrodomestiques, dans le cas où une zone de haute tension et une zone de basse tension sont présentes sur la première face 2A et/ou sur la deuxième face 2B, la zone de haute tension et la zone de basse tension sont séparées d'une distance au moins égale à 5 millimètres sur la première face 2A et/ou sur la deuxième face 2B.

On évite ainsi qu'un composant électronique branché sur une piste de la zone de basse tension, typiquement un composant alimenté avec une tension TBTS, ne soit exposé à une haute tension, typiquement une tension alternative de secteur à 230 Volts.

Comme on peut le voir sur la Figure 3, une surface de projection de la CTN 4 sur la carte électronique 2 selon la direction D est de préférence inférieure à une surface de projection du triac 3 sur la carte électronique 2 selon la direction D. De plus, la projection de la CTN 4 sur la carte électronique 2 selon la direction D est entièrement incluse à l'intérieur de la projection du triac 3 sur la carte électronique 2 selon la direction D.

Autrement dit, le triac 3 s'étend sur une première zone de la première face 2A de la carte électronique 2 et la CTN 4 s'étend sur une deuxième zone de la deuxième face 2B de la carte électronique 2, la première zone étant opposée à la deuxième zone, et la surface de la deuxième zone étant de préférence inférieure à la surface de la première zone.

Un avantage est que la CTN 4 est située en alignement total avec le triac 3 et réagit de manière encore plus fiable et rapide aux variations de température du triac 3.

Selon une variante possible, on place le CTN 4 sur un socle thermique. Le socle thermique, interposé entre la carte électronique 2 et la CTN 4 sur la deuxième face 2B, est composé d'un matériau à forte conductivité thermique. On améliore ainsi encore davantage la réaction du CTN 4 aux variations de température du triac 3.

Bien que l'invention ait été décrite en liaison avec des exemples particuliers de réalisation et d'application, il est bien évident qu'elle n'y est nullement limitée.

Des modifications restent possibles, notamment du point de vue de l'agencement et de la constitution des différents éléments ou par substitution d'équivalents techniques, sans sortir pour autant du domaine de protection de l'invention.

C'est ainsi que bien que répondant à une norme européenne, l'invention peut parfaitement s'appliquer dans d'autres territoires que l'Europe appliquant d'autres standards électriques, notamment en ce qui concerne la valeur de la tension du réseau électrique.

## Revendications

1. Machine (10) de distribution de boissons chaudes respectant des exigences d'isolation électrique définies par la norme européenne EN 60335, la machine comprenant un réservoir (11) pour stocker un liquide, un corps de chauffe (12) prévu pour chauffer une partie de liquide prélevée dans le réservoir (11), une alimentation électrique prévue pour alimenter le corps de chauffe (12) et un système électronique (1) de contrôle du corps de chauffe (12), le système électronique comprenant :
- un substrat électronique (2) comportant une première face (2A) et une deuxième face (2B), chaque face étant séparée par une paroi d'au moins 2mm ou présentant un nombre suffisant de couches pour résister à un test diélectrique de 3000V à un échauffement maximal d'utilisation auquel on rajoute 50 Kelvin,
- au moins une partie opérative du système électronique (1) comportant un composant de puissance (3) configuré pour contrôler l'alimentation électrique du corps de chauffe (12),
- au moins une partie informationnelle du système électronique comportant un capteur de température (4) configuré pour générer un signal caractéristique d'une température observée du composant de puissance (3),
- des moyens de traitement du signal généré par le capteur de température (4), les moyens de traitement étant en outre configurés pour interrompre l'alimentation électrique du composant de puissance (3) lorsque ledit signal dépasse un seuil prédéterminé,
la machine (10) étant **caractérisé en ce que** le composant de puissance (3) est agencé sur la première face (2A) du substrat électronique (2) et le capteur de température est agencé sur la deuxième face (2B) du substrat électronique (2).

2. Machine (10) selon la revendication 1, dans lequel le capteur de température (4) est une thermistance, de préférence du type à coefficient de température négatif.

3. Machine (10) selon l'une quelconque des revendications 1 ou 2, dans lequel le composant de puissance (3) est un triac.

4. Machine (10) selon l'une quelconque des revendications 1 à 3, dans lequel le composant de puissance (3) recouvre une première zone de la première face (2A) du substrat électronique (2) et le capteur de température (4) recouvre une deuxième zone de la deuxième face (2B) du substrat électronique, la première zone étant opposée à la deuxième zone.

5. Machine (10) selon la revendication 4, dans lequel la surface de la deuxième zone est inférieure à la surface de la première zone.

6. Machine (10) selon l'une quelconque des revendications 1 à 5, dans lequel la première face (2A) est sensiblement parallèle à la deuxième face (2B) et le substrat électronique (2) présente une épaisseur comprise entre 1 millimètre et 5 millimètres.

7. Machine (10) selon l'une quelconque des revendications 1 à 6, dans lequel la première face (2A) et la deuxième face (2B) comprennent chacune une partie opérative et une partie informationnelle, chaque partie opérative du système électronique (1) étant séparée d'au moins 5 millimètres de chaque partie informative du système électronique (1).

## Patentansprüche

1. Maschine (10) zur Ausgabe von Heißgetränken, die die durch die europäische Norm EN 60335 definierten Anforderungen an die elektrische Isolierung erfüllt, wobei die Maschine einen Behälter (11) zum Speichern einer Flüssigkeit, einen Heizkörper (12), der zum Erhitzen eines aus dem Behälter (11) entnommenen Flüssigkeitsteils vorgesehen ist, eine elektrische Versorgung, die zum Versorgen des Heizkörpers (12) vorgesehen ist, und ein elektronisches System (1) zum Steuern des Heizkörpers (12) umfasst, wobei das elektronische System umfasst:
- ein elektronisches Substrat (2), das eine erste Seite (2A) und eine zweite Seite (2B) umfasst, wobei jede Seite durch eine Wand von mindestens 2 mm getrennt ist oder eine ausreichende Anzahl von Schichten aufweist, um einem dielektrischen Test von 3000 V bei einer maximalen Betriebserwärmung, zu der 50 Kelvin zugegeben werden, standzuhalten,
- mindestens einen operativen Teil des elektronischen Systems (1), der ein Leistungsbauteil (3) umfasst, das so konfiguriert ist, dass es die elektrische Versorgung des Heizkörpers (12) steuert,
- mindestens einen informationstechnischen Teil des elektronischen Systems, der einen Temperatursensor (4) umfasst, der so konfiguriert ist, dass er ein Signal erzeugt, das für eine beobachtete Temperatur des Leistungsbauteils (3) charakteristisch ist,
- Mittel zur Verarbeitung des vom Temperatursensor (4) erzeugten Signals, wobei die Verarbeitungsmittel weiter so konfiguriert sind, dass sie die elektrische Versorgung des Leistungsbauteils (3) unterbrechen, wenn das Signal eine vorbestimmte Schwelle überschreitet,
wobei die Maschine (10) **dadurch gekennzeichnet ist, dass** das Leistungsbauteil (3) auf der ersten Seite (2A) des elektronischen Substrats (2) angeordnet ist und der Temperatursensor auf der zweiten Seite (2B) des elektronischen Substrats (2) angeordnet ist.

2. Maschine (10) nach Anspruch 1, wobei der Temperatursensor (4) ein Thermistor ist, vorzugsweise vom Typ mit negativem Temperaturkoeffizienten.

3. Maschine (10) nach einem der Ansprüche 1 oder 2, wobei das Leistungsbauteil (3) ein Triac ist.

4. Maschine (10) nach einem der Ansprüche 1 bis 3, wobei das Leistungsbauteil (3) einen ersten Bereich der ersten Seite (2A) des elektronischen Substrats (2) abdeckt und der Temperatursensor (4) einen zweiten Bereich der zweiten Seite (2B) des elektronischen Substrats abdeckt, wobei der erste Bereich dem zweiten Bereich gegenüberliegt.

5. Maschine (10) nach Anspruch 4, wobei die Fläche des zweiten Bereichs kleiner ist als die Fläche des ersten Bereichs.

6. Maschine (10) nach einem der Ansprüche 1 bis 5, wobei die erste Seite (2A) im Wesentlichen zur zweiten Seite (2B) parallel ist und das elektronische Substrat (2) eine Dicke im Bereich zwischen 1 Millimeter und 5 Millimeter aufweist.

7. Maschine (10) nach einem der Ansprüche 1 bis 6, wobei die erste Seite (2A) und die zweite Seite (2B) jeweils einen operativen Teil und einen informationstechnischen Teil umfassen, wobei jeder operative Teil des elektronischen Systems (1) mindestens 5 Millimeter von jedem informationstechnischen Teil des elektronischen Systems (1) getrennt ist.

## Claims

1. A machine (10) for dispensing hot drinks meeting electrical insulation requirements defined by European standard EN 60335, the machine comprising a tank (11) for storing a liquid, a heating body (12) provided to heat a part of liquid taken from the tank (11), an electrical power supply provided to power the heating body (12) and an electronic system (1) for controlling the heating body (12), the electronic system comprising:
- an electronic substrate (2) including a first face (2A) and a second face (2B), each face being separated by a wall of at least 2mm or having a sufficient number of layers to withstand a dielectric test of 3000V at a maximum heating of use to which 50 Kelvin are added,
- at least one operative part of the electronic system (1) including a power component (3) configured to control the electrical power supply of the heating body (12),
- at least one informational part of the electronic system including a temperature sensor (4) configured to generate a signal characteristic of an observed temperature of the power component (3),
- means for processing the signal generated by the temperature sensor (4), the processing means being further configured to interrupt the electrical power supply of the power component (3) when said signal exceeds a predetermined threshold,
the machine (10) being **characterized in that** the power component (3) is arranged on the first face (2A) of the electronic substrate (2) and the temperature sensor is arranged on the second face (2B) of the electronic substrate (2).

2. The machine (10) according to claim 1, wherein the temperature sensor (4) is a thermistor, preferably of the negative temperature coefficient type.

3. The machine (10) according to any one of claims 1 or 2, wherein the power component (3) is a triac.

4. The machine (10) according to any one of claims 1 to 3, wherein the power component (3) covers a first zone of the first face (2A) of the electronic substrate (2) and the temperature sensor (4) covers a second zone of the second face (2B) of the electronic substrate, the first zone being opposite the second zone.

5. The machine (10) according to claim 4, wherein the surface of the second zone is less than the surface of the first zone.

6. The machine (10) according to any one of claims 1 to 5, wherein the first face (2A) is substantially parallel to the second face (2B) and the electronic substrate (2) has a thickness comprised between 1 millimeter and 5 millimeters.

7. The machine (10) according to any one of claims 1 to 6, wherein the first face (2A) and the second face (2B) each comprise an operative part and an informational part, each operative part of the electronic system (1) being separated by at least 5 millimeters from each informative part of the electronic system (1).
